# EUROPEAN PATENT APPLICATION

(11) **EP 4 834 624 A1**
(43) Date of publication of application: **04.11.2026**
(21) Application number: 24911890.2
(22) Date of filing: 27.09.2024
(51) Int. Cl.: B60K 8/00, H01M 8/00, H01M 8/04

(54) **WORK VEHICLE**

(30) Priority: 26.12.2023 JP 2023219336
(71) Applicant: KUBOTA CORPORATION, Osaka-shi, Osaka 530-0011 (JP)
(72) Inventor: FUJIMATSU, Masakatsu, Sakai-shi, Osaka 590-0908 (JP); YASUDA, Soshi, Sakai-shi, Osaka 590-0908 (JP)
(74) Representative: Cabinet Beau de Loménie
(86) International application number: PCT/JP2024/034555
(87) International publication number: WO 2025/141996

(57) **Abstract**

The work vehicle includes: a vehicle body; a fuel cell installed on the vehicle body; a battery unit configured to store electric power generated by the fuel cell; a motor installed on the vehicle body and driven by electric power stored in the battery unit; an equipment case disposed on the battery unit; and a cover that covers the equipment case.

## Description

### TECHNICAL FIELD

The present disclosure relates to a work vehicle. The present application claims priority based on Japanese Patent Application No. 2023-219336 filed on December 26, 2023, the entire contents of which are incorporated herein by reference.

### BACKGROUND ART

PATENT LITERATURE 1 discloses a work vehicle including a fuel cell, a battery, a motor, and a traveling device. The fuel cell generates electric power to be stored in the battery using hydrogen gas. A motor rotates using electric power from the battery, and the traveling device is driven by the rotational force.

### CITATION LIST

### [PATENT LITERATURE]

PATENT LITERATURE 1: Japanese Laid-Open Patent Publication No. 2023-013188

### SUMMARY OF THE INVENTION

The work vehicle of the present disclosure includes: a vehicle body; a fuel cell installed on the vehicle body; a battery unit configured to store electric power generated by the fuel cell; a motor installed on the vehicle body and driven by electric power stored in the battery unit; an equipment case disposed on the battery unit; and a cover that covers the equipment case.

### BRIEF DESCRIPTION OF DRAWINGS

[FIG. 1] FIG. 1 is a perspective view illustrating one embodiment of a work vehicle of the present disclosure.
[FIG. 2] FIG. 2 is a front view of the work vehicle illustrated in FIG. 1.
[FIG. 3] FIG. 3 is a rear view of the work vehicle illustrated in FIG. 1.
[FIG. 4] FIG. 4 is a side view (right side view) of the work vehicle illustrated in FIG. 1.
[FIG. 5] FIG. 5 is a side view (left side view) of the work vehicle illustrated in FIG. 1.
[FIG. 6] FIG. 6 is a plan view of the work vehicle illustrated in FIG. 1.
[FIG. 7] FIG. 7 is a bottom view of the work vehicle illustrated in FIG. 1.
[FIG. 8] FIG. 8 is an exploded perspective view illustrating a portion of the work vehicle illustrated in FIG. 1.
[FIG. 9] FIG. 9 is a right side view of the work vehicle illustrated in FIG. 1 in a state with a hood, a front cover, and a portion of a tank case removed.
[FIG. 10] FIG. 10 is a perspective view of the lower side of the right front side as viewed from the inside of a cabin.
[FIG. 11] FIG. 11 is a perspective view of a relay junction as viewed from the outer side in the vehicle-width direction and from the rear.
[FIG. 12] FIG. 12 is a perspective view of the relay junction as viewed from the inner side in the vehicle-width direction and from the rear.
[FIG. 13] FIG. 13 is a perspective view of a first junction and a second junction with a cover removed, as viewed from the inner side in the vehicle-width direction and from the front.
[FIG. 14] FIG. 14 is a perspective view of the first junction with the cover removed, as viewed from the outer side in the vehicle-width direction and from the front.
[FIG. 15] FIG. 15 is a perspective view of the relay junction in a state in which an openable/closable door of the cover is opened, as viewed from the outer side in the vehicle-width direction and from the front.
[FIG. 16] FIG. 16 is a perspective view of the openable/closable door illustrated in FIG. 11 as viewed from the inner side in the vehicle-width direction.

### DETAILED DESCRIPTION

### <Problems to be Solved by Present Disclosure>

In the above-described work vehicle of PATENT LITERATURE 1, for example, in order to efficiently perform assembly work or maintenance work of an electrical system, an equipment case may be disposed on a battery. However, if mud, soil, or the like splashed up by the traveling device adheres to the equipment case disposed on the battery, work efficiency for the electrical system may be rather lowered.

An object of the present disclosure is to provide a work vehicle capable of efficiently performing work on an electrical system.

### <Effects of Present Disclosure>

According to the present disclosure, work on an electrical system of a work vehicle can be efficiently performed.

### <Outline of Embodiment of Present Disclosure>

Hereinafter, an outline of an embodiment of the present disclosure will be listed and described.
(1) A work vehicle of the present embodiment includes: a vehicle body; a fuel cell installed on the vehicle body; a battery unit configured to store electric power generated by the fuel cell; a motor installed on the vehicle body and driven by electric power stored in the battery unit; an equipment case disposed on the battery unit; and a cover that covers the equipment case.
   According to the work vehicle, since the equipment case disposed on the battery unit is covered by the cover, adhesion of mud, soil, and the like to the equipment case can be suppressed. Thus, work on the electrical system can be performed efficiently.
(2) It is preferable that the work vehicle according to (1) further include a first external terminal provided outside the equipment case, and the cover include: a cover body that covers the equipment case and the first external terminal; and an openable/closable door provided on the cover body for access to the first external terminal.
   In this case, since the first external terminal provided outside the equipment case is covered by the cover body, adhesion of mud, soil, and the like to the first external terminal can be suppressed. Further, by opening the openable/closable door provided on the cover body, the first external terminal covered by the cover body can be easily accessed. Thus, work on the electrical system can be performed more efficiently.
(3) It is preferable that the work vehicle according to (1) or (2) include: a first junction including the equipment case and a first external terminal provided outside the equipment case; and a second junction including a second external terminal disposed on the battery unit, and the cover cover the first junction and the second junction.
   In this case, since the first junction and the second junction arranged on the battery unit are covered by the cover, adhesion of mud, soil, and the like to the first junction and the second junction can be suppressed.
(4) In the work vehicle according to (3), it is preferable that the first external terminal include a first connector to which electric power is input or output, the second external terminal include a second connector to which electric power is input or output, and the first connector be disposed higher than the second connector.
   In this case, the first connector and the second connector are arranged at different positions in the vertical direction. Such arrangement facilitates connection of the cables to the first connectors and the second connectors, respectively, and thus enables work on the electrical system to be performed more efficiently.
(5) In the work vehicle according to (4), it is preferable that the battery unit be disposed outward relative to the vehicle body in the vehicle-width direction, the first connector include a first connection port to which a corresponding cable is connected, the second connector include a second connection port to which a corresponding cable is connected, and each of the first connection port and the second connection port open inward in the vehicle-width direction.
   In this case, the cables connected to the first connection port of the first connector and the second connection port of the second connector can be drawn out inward in the vehicle-width direction. As a result, the wiring length of the cables can be shortened as compared with a case where the cables are drawn out outward in the vehicle-width direction.
(6) In the work vehicle according to (5), it is preferable that the cover include, on an inside in the vehicle-width direction, an opening through which the cables connected to the first connection port and the second connection port are drawn out.
   In this case, the cables connected to the first connection port of the first connector and the second connection port of the second connector can be easily drawn out from the opening of the cover. Thus, work on the electrical system can be performed more efficiently.
(7) In the work vehicle according to (5) or (6), it is preferable that the second junction be disposed inward relative to the first junction in the vehicle-width direction on the battery unit.
   In this case, the second connector of the second junction is disposed inward in the vehicle-width direction and on the lower side relative to the first connector of the first junction. Such arrangement further facilitates connection of the cables to the first connectors and the second connectors, and thus enables work on the electrical system to be performed more efficiently.
(8) In the work vehicle according to (7), it is preferable that the cover include: a cover body that covers the first junction and the second junction; and an openable/closable door provided outside the cover body in the vehicle-width direction.
   In this case, by opening the openable/closable door, the first junction covered by the cover body can be easily accessed. Thus, work on the electrical system can be performed more efficiently.
(9) In the work vehicle according to (8), it is preferable that the first external terminal include a service plug provided outside the equipment case in the vehicle-width direction and configured to interrupt a power path, and the service plug be disposed near the openable/closable door.
   In this case, by opening the openable/closable door, easy access can be made to the service plug covered by the cover body. As a result, interruption of a power path by the service plug can be easily performed.
(10) In the work vehicle according to (8) or (9), it is preferable that the first external terminal include a voltage detection unit that is provided outside the equipment case in the vehicle-width direction and that checks energization of a power path, and the voltage detection unit be disposed near the openable/closable door.
   In this case, by opening the openable/closable door, the voltage detection unit covered by the cover body can be easily accessed. As a result, energization of the power path can be easily checked by the voltage detection unit.
(11) It is preferable that the work vehicle according to any one of (1) to (10) further include: a driver's seat installed on the vehicle body; a cabin having the driver's seat therein; and a traveling device including a front wheel and a rear wheel, the battery unit be disposed between the front wheel and the rear wheel outward relative to the vehicle body in the vehicle-width direction, and the equipment case be disposed in front of the cabin on the battery unit.
   In this case, since the equipment case is disposed in front of the cabin, the equipment case can be disposed on the battery unit without interfering with the cabin.
(12) In the work vehicle according to (11), it is preferable that the cabin include a windshield, and the cover be disposed at a position visually recognizable from the driver's seat through the windshield.
   In this case, a worker sitting on the driver's seat can easily visually recognize, through the windshield of the cabin, that the equipment case is covered by the cover.
(13) In the work vehicle according to (11), it is preferable that the cabin include the cabin includes a side window, and the cover be disposed at a position visually recognizable from the driver's seat through the side window.

In this case, a worker sitting on the driver's seat can easily visually recognize, through the side window of the cabin, that the equipment case is covered by the cover.

### <Details of Embodiment of Present Disclosure>

A preferred embodiment will be described below with reference to the drawings.

### [Overall Configuration of Work Vehicle]

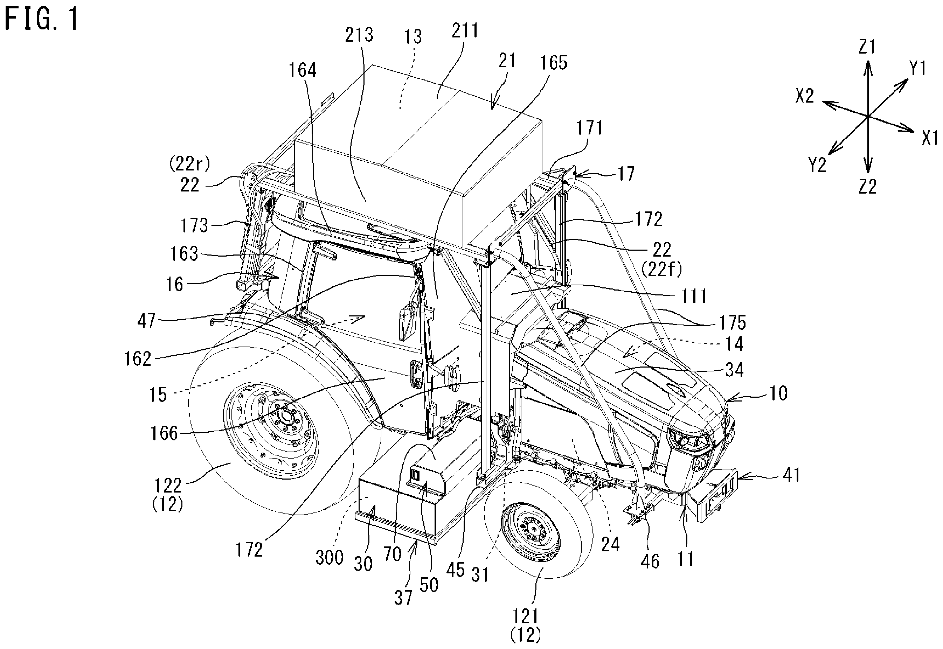

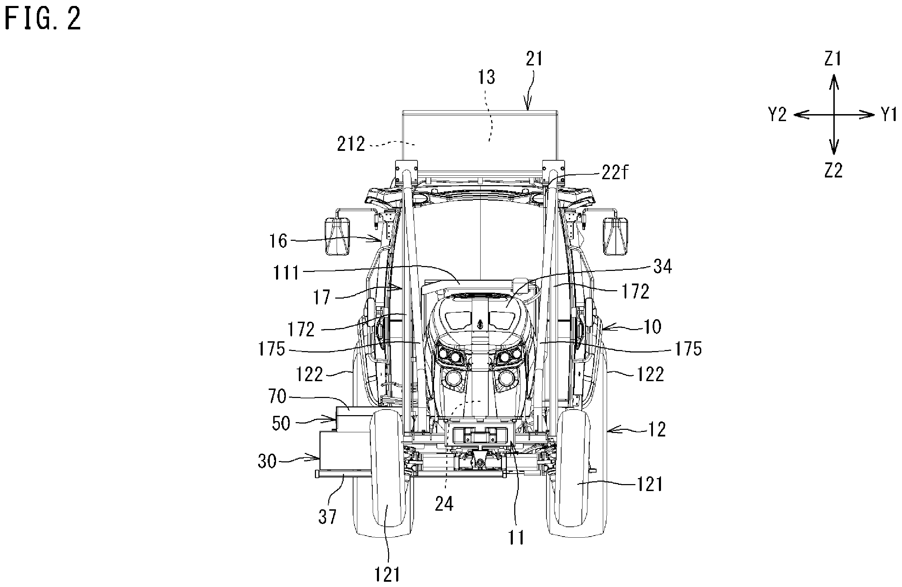

FIG. 1 is a perspective view illustrating an embodiment of a work vehicle of the present disclosure. FIG. 2 to FIG. 7 are a front view, a rear view, a side view (right side view), a side view (left side view), a plan view, and a bottom view of the work vehicle illustrated in FIG. 1.

A work vehicle 10 of the present embodiment is a vehicle that can be used for farmwork, and the work vehicle 10 illustrated in FIG. 1 is a tractor. The work vehicle is not limited to a tractor. For example, the work vehicle according to the present disclosure may be an agricultural machine other than a tractor, a construction machine, a utility vehicle, or the like.

Directions of the work vehicle 10 of the present disclosure are defined. A direction in which the work vehicle 10 moves forward is defined as front, a direction in which the work vehicle 10 moves rearward is defined as rear, a left side of the work vehicle 10 facing forward is defined as left, and a right side of the work vehicle 10 facing forward is defined as right. The front-rear direction of the work vehicle 10 is defined as a vehicle front-rear direction. A left-right direction orthogonal to the vehicle front-rear direction is defined as a vehicle-width direction. A direction orthogonal to both the vehicle front-rear direction and the vehicle-width direction is defined as a vertical direction. The vertical direction is also referred to as a height direction.

In each figure, an orthogonal three-dimensional coordinate is illustrated, and the front direction is indicated by an arrow X1 and the rear direction is indicated by an arrow X2. The left direction is indicated by an arrow Y1, and the right direction is indicated by an arrow Y2. The upward direction is indicated by an arrow Z1, and the downward direction is indicated by an arrow Z2.

The work vehicle 10 illustrated in FIG. 1 includes a vehicle body 11, a traveling device 12 that supports the vehicle body 11 in a travelable manner, a driver's seat 15, a cabin 16, a tank unit 21 including a tank 13 that stores fuel, and a drive device 14 that is driven by the fuel stored in the tank 13. The fuel is liquid or gas, and is, for example, hydrogen, methane, carbon monoxide (CO), or the like. In the present embodiment, the tank 13 stores hydrogen gas. The work vehicle 10 according to the present embodiment is a fuel cell vehicle (FCV) that travels using electric power generated by a fuel cell (fuel cell module) 24 using hydrogen and oxygen. The fuel cell 24 may generate electric power using methane or carbon monoxide (CO) as fuel.

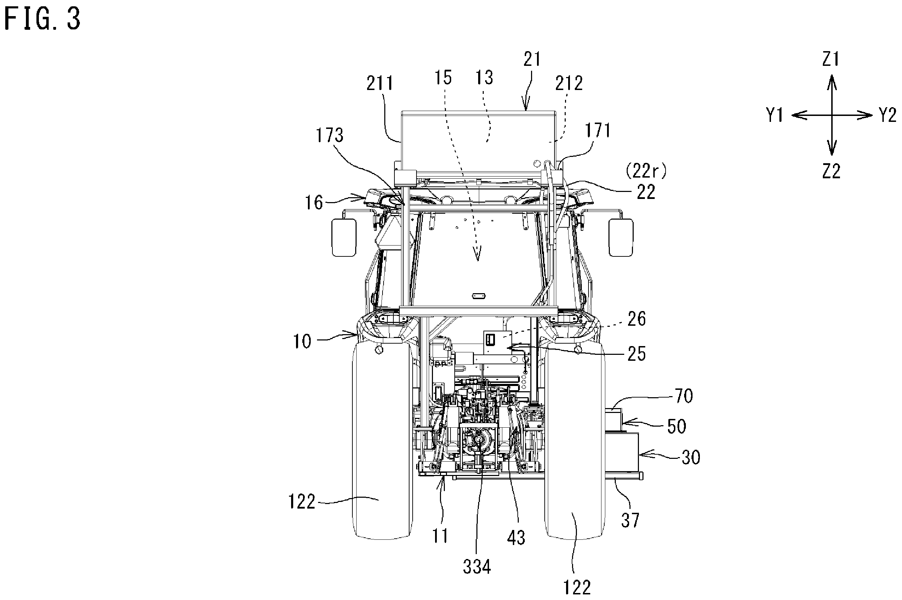

The drive device 14 includes the fuel cell 24, a battery unit 30, and an electric motor 31. The battery unit 30 includes a battery 300 that stores the electric power generated by the fuel cell 24. The motor 31 is driven by the electric power stored in the battery 300. The work vehicle 10 includes pipes (hydrogen pipes) 22 for hydrogen gas and a filling unit 25 (see FIG. 3). The filling unit 25 has a filling port (receptacle) 26 to which a filling nozzle of a hydrogen gas supply machine (not illustrated) separate from the work vehicle 10 is connected. Hydrogen gas is supplied from the filling port 26 and is supplied to the tank 13 through the pipe 22 (rear pipe 22r). Hydrogen gas in the tank 13 is supplied to the fuel cell 24 through a pipe 22 (front pipe 22f).

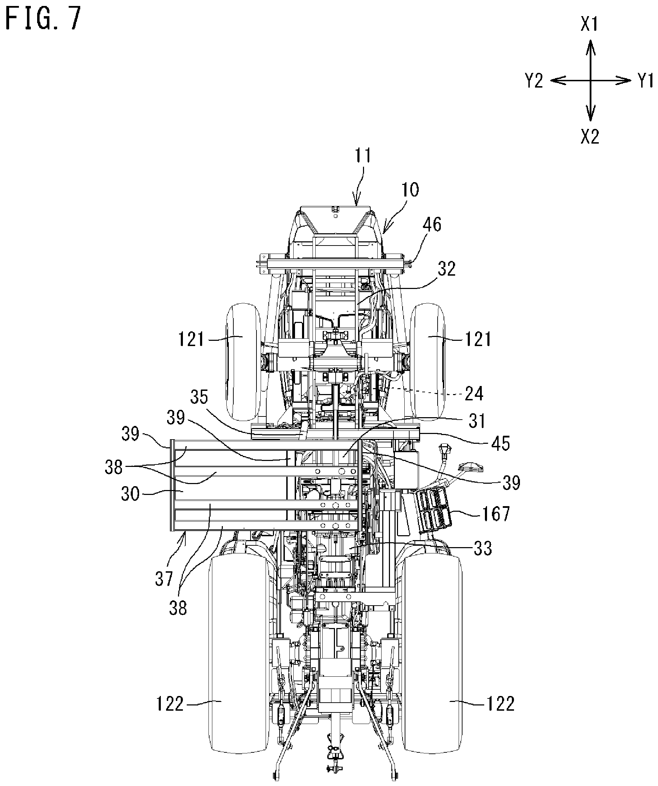

The work vehicle 10 (see FIG. 1) includes an installation frame 17 and a support frame 37. The installation frame 17 is a frame for installing the tank unit 21 (tank 13) on the vehicle body 11. The support frame 37 is a frame for supporting the battery unit 30 on the vehicle body 11. A specific configuration of the installation frame 17 and the support frame 37 will be described below. The work vehicle 10 (see FIG. 7) includes a discharge path 35. The discharge path 35 discharges water or water vapor generated by the power generation of the fuel cell 24 to the outside.

### [Vehicle Body]

The vehicle body 11 includes a chassis 41, a hood 34, a front cover 111, and fenders 47. The fenders 47 cover rear wheels 122 from above.

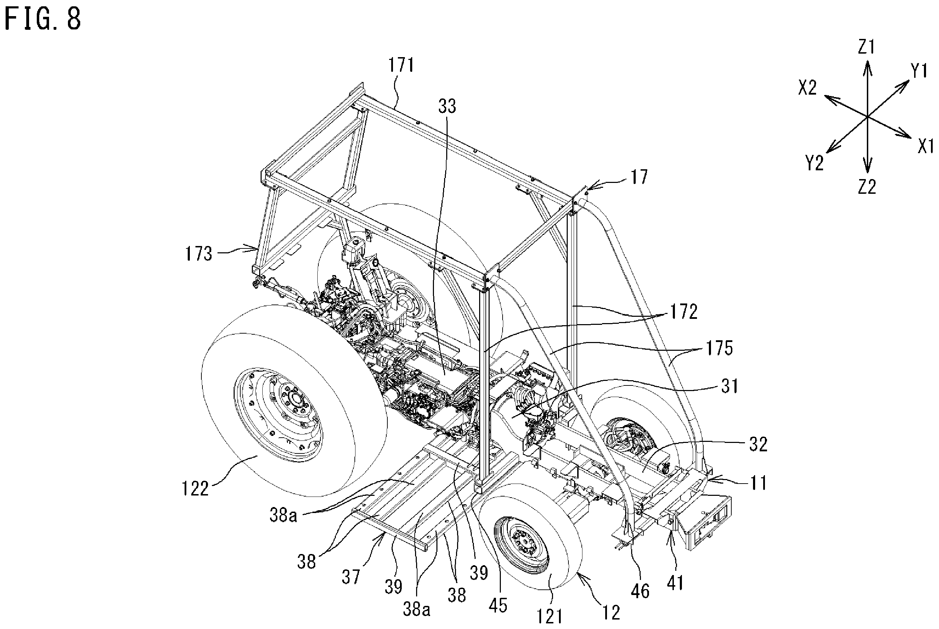

The chassis 41 supports the traveling device 12, the drive device 14, and the cabin 16. FIG. 8 is an exploded perspective view of a portion of the work vehicle 10 illustrated in FIG. 1. The chassis 41 is located at the center in the vehicle-width direction and has a long shape in the vehicle front-rear direction. The chassis 41 includes a front frame 32 serving as a front portion of the chassis 41, a gear case 33 serving as a rear portion of the chassis 41, and a first lateral frame 45 and a second lateral frame 46 extending in the vehicle-width direction.

The front frame 32, the first lateral frame 45, and the second lateral frame 46 are formed by combining metal frame members and the like. The motor 31 is installed on the front frame 32. The first lateral frame 45 is fixed to the front frame 32 at the rear of front wheels 121. The second lateral frame 46 is fixed to the front frame 32 in front of the front wheels 121. Both ends in the vehicle-width direction of each of the first lateral frame 45 and the second lateral frame 46 extend outward in the vehicle-width direction relative to the front frame 32 (see FIG. 7).

The gear case 33 includes a metal box. The gear case 33 is coupled to the rear portion of the front frame 32, and the gear case 33 and the front frame 32 form the frame of the vehicle body 11. The gear case 33 includes a power transmission mechanism such as a transmission, a clutch, and a differential gear therein. The power transmission mechanism decelerates or accelerates the rotation of the output shaft of the motor 31, and outputs the rotation to the traveling device 12 (one or both of the front wheels 121 and the rear wheels 122).

The power transmission mechanism outputs a portion of the power of the motor 31 to a PTO shaft 334 (see FIG. 3). The PTO shaft 334 is an output shaft provided at a rear portion of the gear case 33. The work vehicle 10 includes a coupling device 43 for coupling a separate instrument at the rear of the vehicle body 11. The PTO shaft 334 transmits power of the motor 31 to the separate instrument coupled to the coupling device 43. The separate instrument is a working device (not illustrated), and is also called an implement. The working device is operated by power of the motor 31. The working device is, for example, a cultivator or the like.

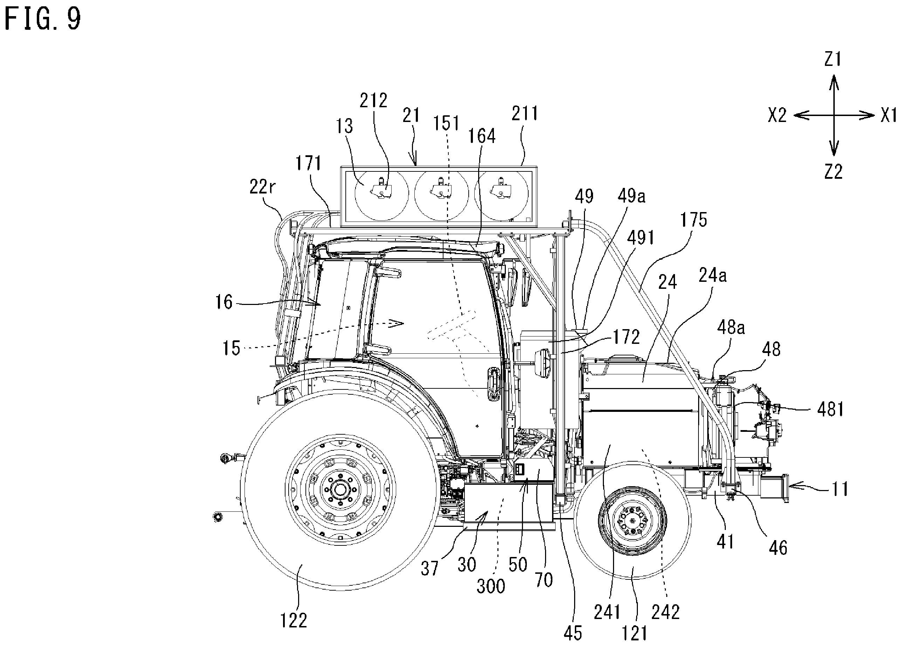

FIG. 9 is a right side view of the work vehicle 10 in a state in which the hood 34, the front cover 111, and a portion of a tank case 211 of the tank unit 21 are removed. A first radiator 48, the fuel cell 24, and a second radiator 49 are installed on the chassis 41 in this order from the front of the vehicle.

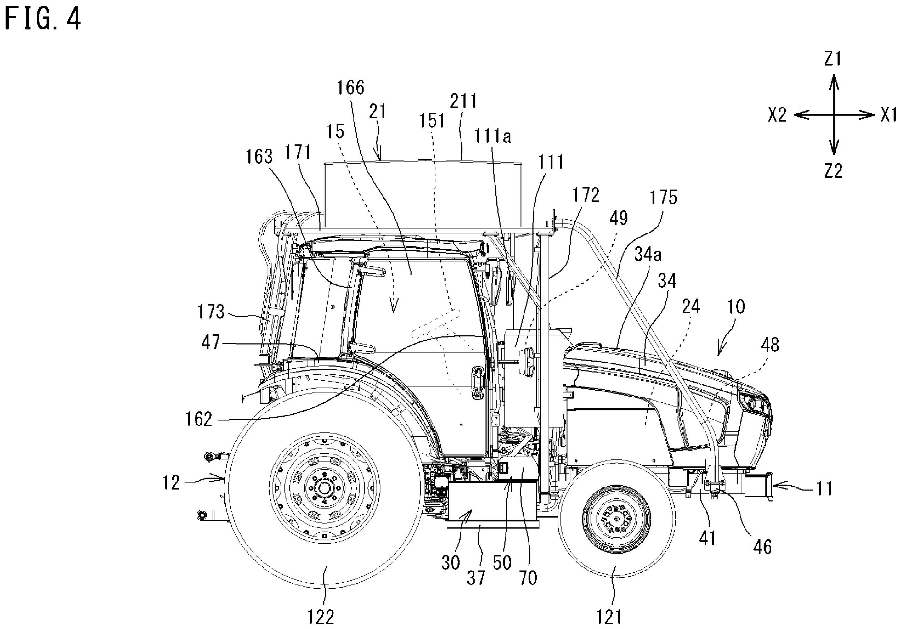

As illustrated in FIG. 4 and FIG. 9, the hood 34 and the front cover 111 cover installed components positioned close to the front of the vehicle body 11. The hood 34 covers the fuel cell 24 and the first radiator 48 from above and from both sides in the vehicle-width direction. The front cover 111 covers the second radiator 49 positioned at the rear of the fuel cell 24 from above and from both sides in the vehicle-width direction.

An upper surface 48a of the first radiator 48 is lower than an upper surface 24a of the fuel cell 24. The upper surface 24a of the fuel cell 24 is lower than an upper surface 49a of the second radiator 49.

An upper surface 111a of the front cover 111 is higher than an upper surface 34a of the hood 34, but is lower than the upper end of a steering wheel 151 operated for steering by a worker sitting on the driver's seat 15. The upper surface 34a of the hood 34 is lower toward the front. Therefore, the field of view of the worker sitting on the driver's seat 15 is less likely to be obstructed.

### [Driver's Seat and Cabin]

The driver's seat 15 and the cabin 16 are provided on the chassis 41 at positions close to the rear (see FIG. 1). The cabin 16 includes a driver's seat 15 and the steering wheel 151 therein.

The cabin 16 includes front pillars 162 positioned in front of the driver's seat 15, rear pillars 163 positioned at the rear of the driver's seat 15, and a roof 164 positioned above the driver's seat 15. The front pillars 162 are provided on a left front side and a right front side of the driver's seat 15. The rear pillars 163 are provided at the rear-left and the rear-right of the driver's seat 15. The roof 164 is supported by the front pillars 162 and the rear pillars 163.

The cabin 16 includes a transparent windshield 165 positioned in front of the driver's seat 15, and transparent side windows 166 positioned on left and right sides of the driver's seat 15. The windshield 165 is provided between the left and right front pillars 162. The side windows 166 are provided between the front pillars 162 and the rear pillars 163. The windshield 165 and the side windows 166 are each provided over the entirety from the ceiling to the floor surface of the cabin 16. The side windows 166 are openable and closable, and function as doors through which a worker enters and exits the cabin 16.

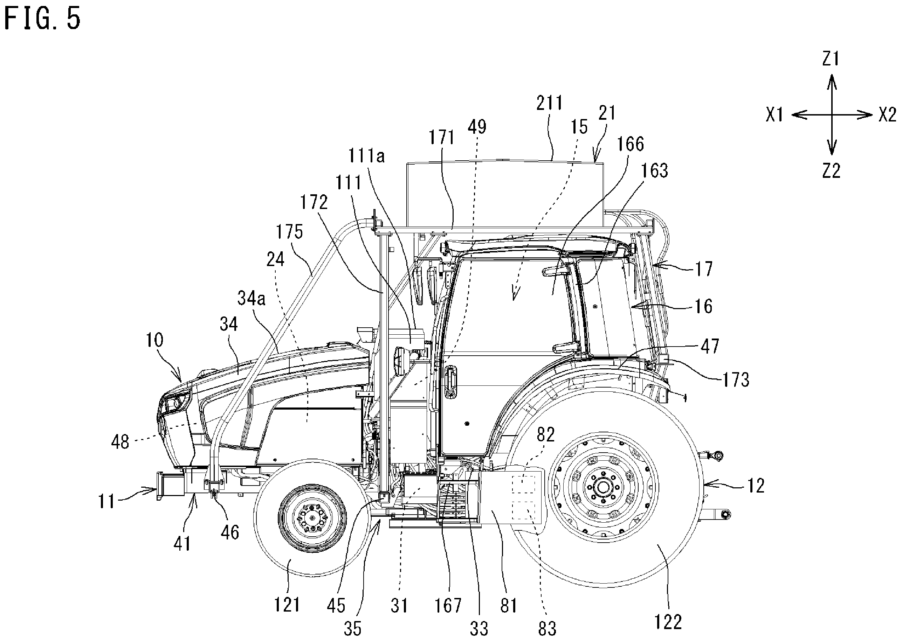

A step 167 is provided on one side (left side) of the cabin 16 in the vehicle-width direction (see FIG. 5). The step 167 is a member on which a worker who gets on and off the cabin 16 places his/her foot.

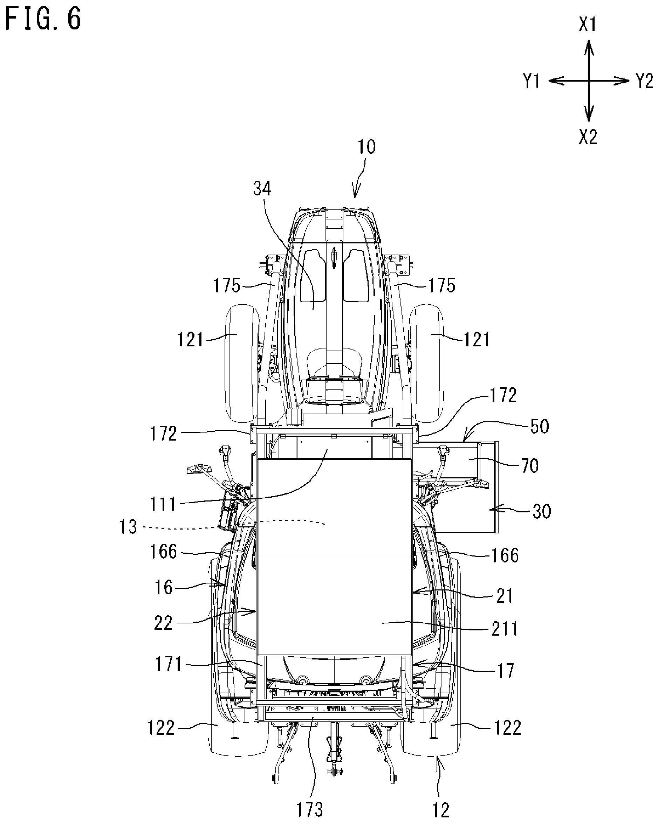

The front cover 111 and the hood 34 are provided in front of the cabin 16. As illustrated in FIG. 2 and FIG. 6, the sizes of the front cover 111 and the hood 34 in the vehicle-width direction are smaller than the sizes of the cabin 16 in the vehicle-width direction. The size of the hood 34 in the vehicle-width direction is smaller than the size of the front cover 111 in the vehicle-width direction.

The work vehicle 10 of the present embodiment includes a cabin 16, but the work vehicle 10 does not necessarily include the cabin 16. The work vehicle 10 may have a canopy or a rollover protective structure (ROPS) instead of the cabin 16. When the work vehicle 10 does not include the cabin 16, the tank unit 21 is installed on the installation frame 17 and positioned above the driver's seat 15.

### [Traveling Device 12]

The traveling device 12 includes the front wheels 121 and the rear wheels 122 (see FIG. 6). The front wheels 121 are provided on the left and right of the front portion of the vehicle body 11. The rear wheels 122 are provided on the left and right of the rear portion of the vehicle body 11. The maximum size of the left and right rear wheels 122 in the vehicle-width direction is larger than the maximum size of the left and right front wheels 121 in the vehicle-width direction. The maximum size of the left and right rear wheels 122 in the vehicle-width direction is the maximum vehicle width size of the work vehicle 10.

One or both of the front wheels 121 and the rear wheels 122 are rotated by the power of the motor 31. One or both of the front wheels 121 and the rear wheels 122 (drive wheels) rotated by the power of the motor 31 may be crawlers (caterpillars).

### [Drive Device]

As described above, the drive device 14 includes the fuel cell 24, the battery unit 30, and the motor 31.

The fuel cell 24 is on the chassis 41 at a position close to the front of the vehicle body 11 (see FIG. 9). The motor 31 is positioned at the rear of the fuel cell 24 (see FIG. 8). The battery unit 30 is disposed between the front wheel 121 and the rear wheel 122 outward with respect to the vehicle body 11 in the vehicle-width direction (see FIG. 1). A rear portion of the battery unit 30 is disposed below the cabin 16, and a front portion of the battery unit 30 is disposed in front of the cabin 16.

The fuel cell 24 generates electric power using hydrogen gas supplied from the battery unit 30 as fuel, and obtains electric power for rotating the motor 31. The fuel cell 24 includes a cell casing 241 having a substantially rectangular box shape and a fuel cell stack 242 provided inside the cell casing 241. The fuel cell stack 242 includes a plurality of battery cells. The battery cells each have a positive electrode and a negative electrode. The plurality of battery cells are in a stacked state. The electric power generated by the battery cells is aggregated and output to the battery unit 30.

The motor 31 includes a rotating rotor and a stator having a plurality of coils. An output shaft of the motor 31 is coupled to the power transmission mechanism in the gear case 33 (see FIG. 8). The motor 31 is positioned at the rear of the fuel cell 24 and below the second radiator 49.

The battery unit 30 is installed on the support frame 37 attached to the chassis 41 (see FIGs. 7 and 8). The support frame 37 is a frame structure and is positioned between the front wheel 121 and the rear wheel 122. The support frame 37 of the present embodiment includes a plurality of fixed frame portions 38 extending outward in the vehicle-width direction from the chassis 41, and a plurality of coupling frame portions 39 extending in the vehicle front-rear direction to couple the plurality of fixed frame portions 38.

An inner end of each fixed frame portion 38 in the vehicle-width direction is fixed to the gear case 33. The plurality of coupling frame portions 39 couple outer end portions, intermediate portions, and inner end portions of the plurality of fixed frame portions 38 in the vehicle-width direction. An upper surface of each fixed frame portion 38 between the two coupling frame portions 39 disposed at the outer end portion and the intermediate portion in the vehicle-width direction is a mount surface 38a on which the battery unit 30 is mounted. The battery unit 30 is mounted on the mount surface 38a of each fixed frame portion 38, thereby being disposed outward with respect to the vehicle body 11 in the vehicle-width direction.

### [Tank Unit]

The tank unit 21 (see FIG. 9) includes the tanks 13, the tank case 211 that houses the tanks 13, and a valve unit 212. The tanks 13 are substantially cylindrical high-pressure containers. The tanks 13 are made of a fiber-reinforced resin or the like reinforced with carbon fibers or glass fibers. In the present embodiment, the three tanks 13 are fixed to the tank case 211 with the axial direction of the cylindrical portions parallel to the vehicle-width direction. The number of tanks 13 is not limited to 3.

The tank case 211 is a box capable of housing one or a plurality of tanks 13. The tank case 211 has an openable/closable door 213 (see FIG. 1) on one or both sides in the vehicle-width direction, and is openable in the vehicle-width direction. The tank case 211 is placed above the roof 164 at a distance from the roof 164 in the vertical direction. The tank case 211 is fixed to an upper frame portion 171 of the installation frame 17. The tank case 211 is made of metal such as aluminum or steel, and protects the tank 13 against thermal and physical influences from the outside.

The tanks 13 are disposed above the cabin 16 (driver's seat 15). Therefore, a degree of freedom in arrangement of the fuel cell 24, the filling unit 25, the motor 31, and the battery unit 30 in the vehicle body 11 is high. Conversion of a conventional work vehicle using a conventional internal combustion engine into the work vehicle 10 including the fuel cell 24 and the motor 31 as in the present embodiment does not require significant change of the arrangement configuration of instruments.

The tanks 13 are coupled to the rear pipe 22r and the front pipe 22f via a valve unit 212 (see FIG. 9). The rear pipe 22r (see FIG. 3) is a gas inlet pipe line connecting the filling port 26 for hydrogen gas and the valve unit 212, and guides hydrogen gas introduced into the filling port 26 to the tanks 13. The front pipe 22f (see FIG. 2) is a gas outlet pipe line connecting the fuel cell 24 and the valve unit 212, and guides hydrogen gas stored in the tanks 13 to the fuel cell 24. The tanks 13 store hydrogen gas introduced into the filling port 26 from the outside of the vehicle, and supply the hydrogen gas to the fuel cell 24. The valve unit 212 includes an on-off valve, a pressure reducing valve, and the like to adjust the flow rate of the hydrogen gas stored in the tanks 13 to a predetermined flow rate, and guides the hydrogen gas to the fuel cell 24 through the front pipe 22f.

### [Installation Frame]

As illustrated in FIGs. 1 and 8, the installation frame 17 is a frame structure for installing the tank 13 on the vehicle body 11. The installation frame 17 of the present embodiment includes the upper frame portion 171, a pair of front frame portions 172, a rear frame portion 173, and a pair of reinforcing frame portions 175.

The upper frame portion 171 is formed in a rectangular frame shape and is positioned above the cabin 16. The tank case 211 is attached to the upper frame portion 171. That is, the upper frame portion 171 supports the tanks 13 via the tank case 211. The upper frame portion 171 is supported by the front frame portions 172, the rear frame portion 173, and the reinforcing frame portions 175.

The pair of front frame portions 172 extend in the vertical direction in front of the cabin 16 and outward with respect to the vehicle body 11 in the vehicle-width direction. Upper ends of the pair of front frame portions 172 are fixed to left and right corner portions on the front side of the upper frame portion 171. Lower ends of the pair of front frame portions 172 are fixed to both end portions, in the vehicle-width direction, of the first lateral frame 45 of the chassis 41.

The rear frame portion 173 is positioned at the rear of the cabin 16. The rear frame portion 173 is configured in a lattice shape by a plurality of frame members. Upper ends of the rear frame portion 173 are fixed to left and right corner portions on the rear side of the upper frame portion 171. The lower end of the rear frame portion 173 is fixed to the chassis 41. On the rear frame portion 173, the filling unit 25 is provided (see FIG. 3).

The pair of reinforcing frame portions 175 are reinforcement members for receiving an inertial force that causes the upper frame portion 171 and the tank case 211 to move forward when the work vehicle 10 traveling stops. The pair of reinforcing frame portions 175 are positioned in front of the front frame portion 172 and on both sides of the hood 34 in the vehicle-width direction. Upper ends of the pair of reinforcing frame portions 175 are fixed to left and right corner portions on the front side of the upper frame portion 171. Lower ends of the pair of reinforcing frame portions 175 are fixed to both end portions, in the vehicle-width direction, of the second lateral frame 46 of the chassis 41 (see FIG. 2).

### [Inverter and Voltage Converters]

The work vehicle 10 (see FIG. 5) includes an inverter 81, a first voltage converter 82, and a second voltage converter 83. The inverter 81 is positioned near the inside of the left rear wheel 122 in the vehicle-width direction. The inverter 81 is attached to the chassis 41.

The first voltage converter 82 and the second voltage converter 83 are positioned inward relative to the inverter 81 in the vehicle-width direction and outward relative to the chassis 41 in the vehicle-width direction. The first voltage converter 82 and the second voltage converter 83 are attached to the chassis 41 in a state arranged vertically. In the present embodiment, the first voltage converter 82 is positioned above, and the second voltage converter 83 is positioned below. The first voltage converter 82 is, for example, a 12 V DC/DC converter. The second voltage converter 83 is, for example, a 24 V DC/DC converter.

### [Radiator]

The work vehicle 10 (see FIG. 4 and FIG. 5) includes a cooling system that cools the fuel cell 24, the motor 31, the inverter 81, the voltage converters 82 and 83, and the like with coolant. As a portion of the cooling system, the work vehicle 10 includes the first radiator 48 and the second radiator 49. As illustrated in FIG. 9, the first radiator 48 is positioned in front of the fuel cell 24, and the second radiator 49 is positioned at the rear of the fuel cell 24.

The first radiator 48 is a radiator for cooling instruments other than the fuel cell 24. The second radiator 49 is a radiator for cooling the fuel cell 24.

The first radiator 48 is connected, via a first cooling flow channel (not illustrated) including a circulation pump, to electrical components (heat generating components) that require cooling such as the motor 31, the inverter 81, and the voltage converters 82 and 83. The first radiator 48 cools the coolant that is supplied through the first cooling flow channel by heat exchange with the external air.

The second radiator 49 is connected to the fuel cell 24 via a second cooling flow channel (not illustrated) including a circulation pump. The second radiator 49 cools the coolant supplied through the second cooling flow channel by heat exchange with the external air.

The first radiator 48 includes a first fan 481. The second radiator 49 includes a second fan 491. The first fan 481 and the second fan 491 rotate to cause air to pass through the first radiator 48 and the second radiator 49, thereby promoting heat exchange with the coolant.

### [Battery Unit]

The battery unit 30 stores electric power to be supplied to the motor 31. The battery unit 30 (see FIG. 9) includes a battery (battery pack) 300 and a battery housing 301 that houses the battery 300. The battery 300 temporarily stores electric power generated by the fuel cell 24, and outputs the stored electric power to an electric device such as the motor 31. The battery 300 includes a plurality of battery cells. The battery 300 is a charge/discharge secondary battery such as a lithium ion battery or a lead storage battery. The battery housing 301 has a rectangular parallelepiped shape that is long in the vehicle-width direction. The lower surface of the battery housing 301 is mounted on a mount surface 38a of the support frame 37 (see FIG. 8) and fixed in that state.

### [Electrical System]

The work vehicle 10 (see FIG. 9) includes a relay junction 50. The relay junction 50 is an electrical connection box for relay connection and distribution of electric power output from the battery unit 30.

The fuel cell 24 is connected to the inverter 81 (see FIG. 5) via a step-up circuit (not illustrated). The battery unit 30 is connected to the inverter 81 through the relay junction 50. The inverter 81 is electrically connected to the motor 31. The inverter 81 converts DC power output from the step-up circuit into three-phase AC power and outputs the three-phase AC power to the motor 31.

The battery unit 30 is connected to the first voltage converter 82 and the second voltage converter 83 through the relay junction 50. The first voltage converter 82 and the second voltage converter 83 constitute a step-down circuit that steps down electric power input from the battery unit 30.

The work vehicle 10 includes low-voltage electrical components that operate at a voltage lower than that of the motor 31. In the present embodiment, the low-voltage electrical components include radiators 48 and 49, and an air conditioner (not illustrated), for example. Electric power stepped down by the step-down circuit (the voltage converters 82 and 83 or a 12 V battery) is supplied to the low-voltage electrical components through the relay junction 50.

### [Relay Junction]

The relay junction 50 (see FIGs. 1, 4, and 6) is disposed on the battery unit 30 (see FIG. 4). The battery unit 30 is installed on the support frame 37 as described above, and disposed, in that state, between the first lateral frame 45 (front frame portion 172) and the rear wheel 122 on the right side of the vehicle body 11. A portion of the battery unit 30 is disposed so as to extend below the right part of the cabin 16. Another portion of the battery unit 30 protrudes to the right of the cabin 16 (see FIG. 6) and protrudes forward from the cabin 16 (see FIG. 4).

The relay junction 50 is mounted on a front part of the battery unit 30 in a manner not to protrude from the battery unit 30 toward both sides in the vehicle-width direction or forward. In the present embodiment, the relay junction 50 is disposed in front of the cabin 16 and at the rear of the front frame portion 172, on the front part of the battery unit 30. In the present embodiment, the relay junction 50 is disposed at the rear-right side of the hood 34 and at the lower-right side of the front cover 111.

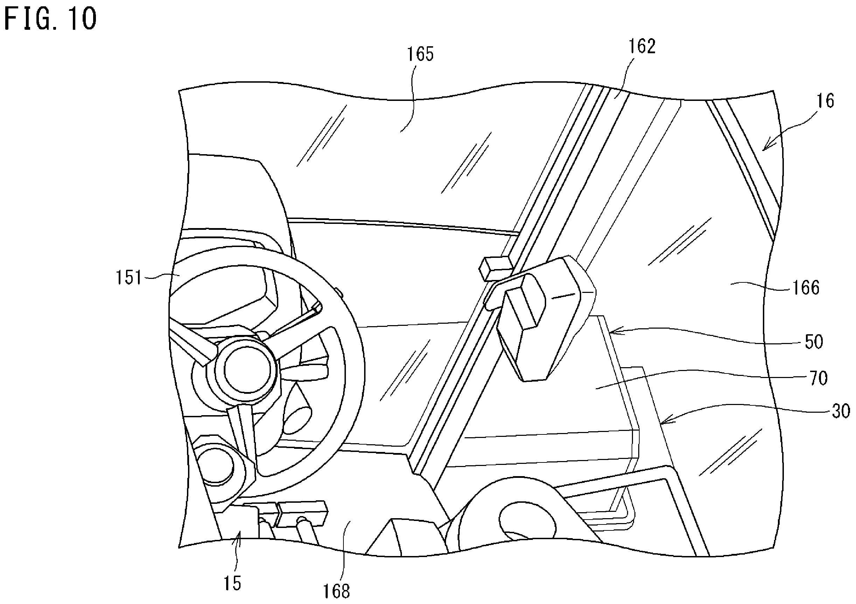

FIG. 10 is a perspective view of the lower side of the right front side as viewed from the inside of the cabin 16. As illustrated in FIG. 10, the relay junction 50 is mounted in front of the windshield 165 on the battery unit 30, and mounted to protrude to the right from the right side window 166. The right part of the lower end of the windshield 165 where the relay junction 50 is disposed reaches the bottom portion 168 of the cabin 16, or reaches a position close to the bottom portion 168. The front part of the lower end of the right side window 166 where the relay junction 50 is disposed reaches the bottom portion 168 of the cabin 16, or reaches a position close to the bottom portion 168. Accordingly, the relay junction 50 (particularly, a cover 70 described below) is disposed at a position visible from the driver's seat 15 in the cabin 16 through the windshield 165 and through the side window 166.

The front cover 111 (see FIGs. 1, 4, and 6) is disposed on the pair of front frame portions 172 in front of the windshield 165 of the cabin 16. The front cover 111 is disposed at an intermediate height position in the vertical direction of the front frame portions 172 in side view. A lower-right end of the front cover 111 is disposed above the relay junction 50. That is, the relay junction 50 is disposed between the front cover 111 and the battery unit 30 in the vertical direction in right side view.

The hood 34 is disposed on the vehicle body 11 in front of the front cover 111. The rear-right end of the hood 34 is disposed in front of the relay junction 50. That is, the relay junction 50 is disposed between the windshield 165 of the cabin 16 and the hood 34 in the vehicle front-rear direction in right side view.

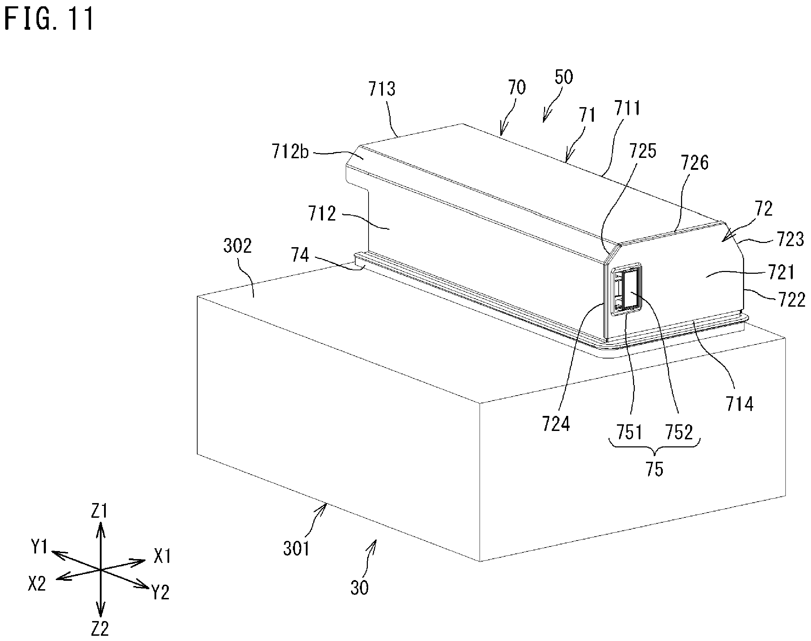

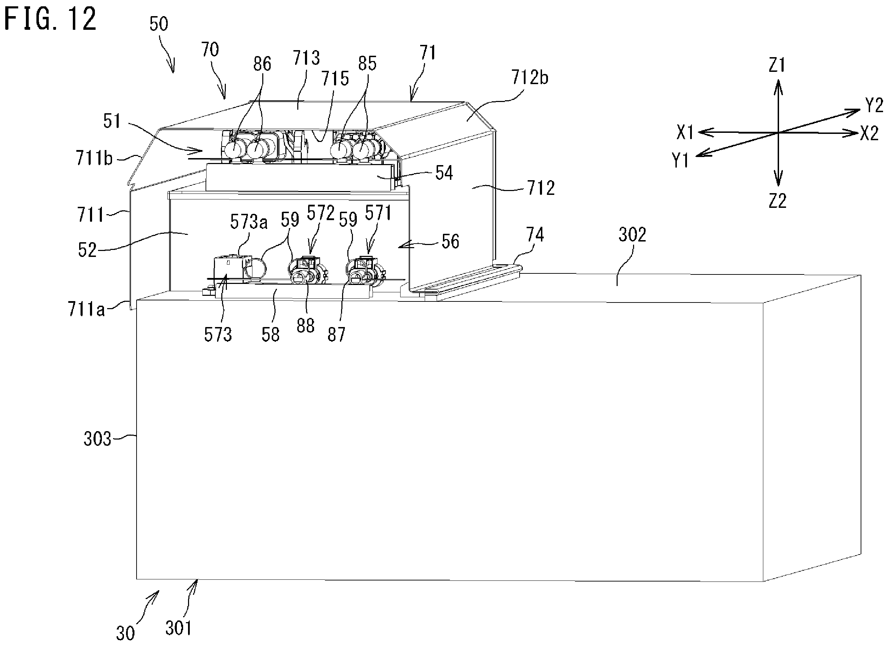

FIG. 11 is a perspective view of the relay junction 50 as viewed from the outer side in the vehicle-width direction and from the rear. FIG. 12 is a perspective view of the relay junction 50 as viewed from the inside in the vehicle-width direction and from the rear. As illustrated in FIGs. 11 and 12, the relay junction 50 includes a first junction 51, a second junction 56, and the cover 70. The cover 70 covers the first junction 51 and the second junction 56.

### [First Junction]

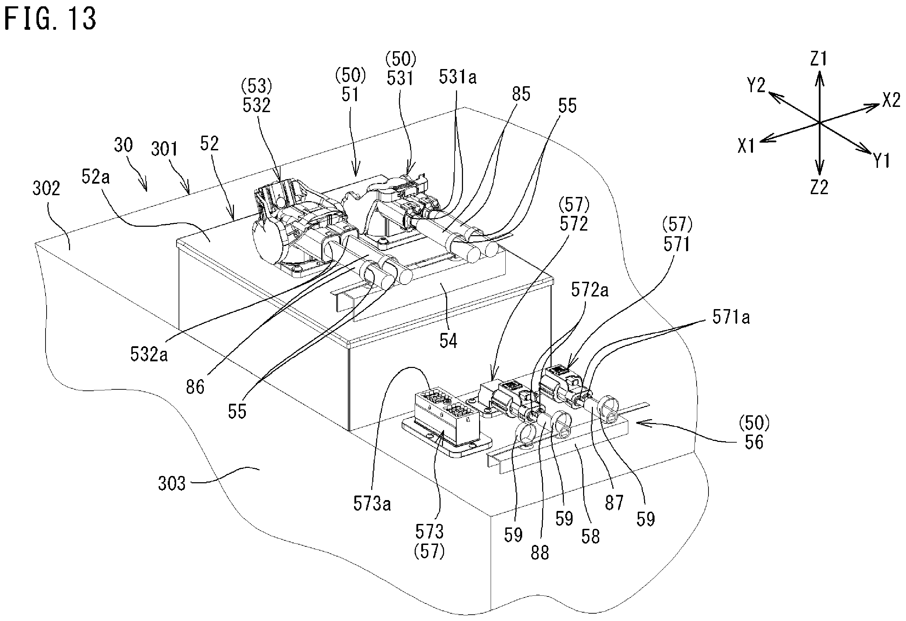

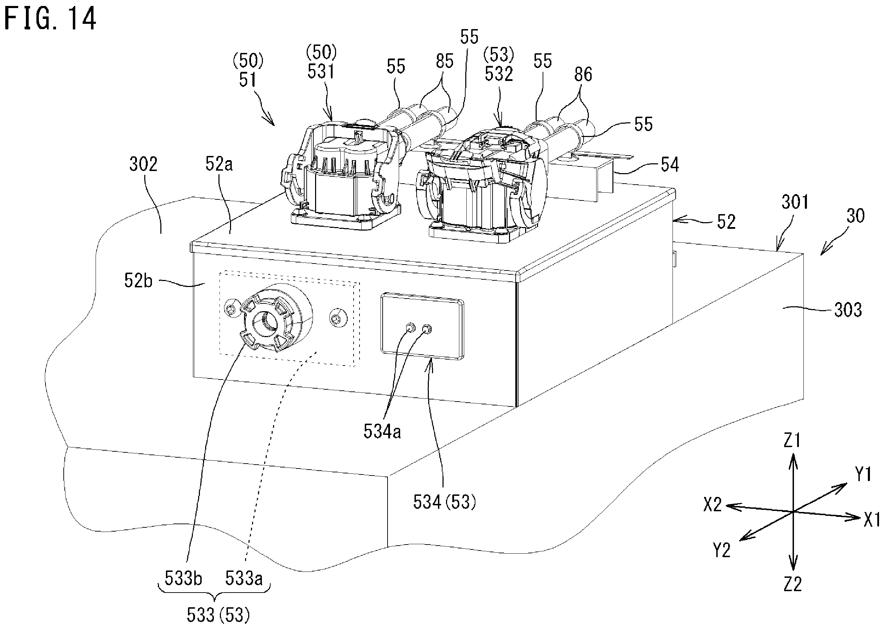

FIG. 13 is a perspective view of the first junction 51 and the second junction 56 with the cover 70 removed, as viewed from the inside in the vehicle-width direction and from the front. FIG. 14 is a perspective view of the first junction 51 with the cover 70 removed, as viewed from the outer side in the vehicle-width direction and from the front. As illustrated in FIGs. 13 and 14, the first junction 51 has an equipment case 52 that houses a device (not illustrated), and a plurality of first external terminals 53 provided outside the equipment case 52.

The equipment case 52 is disposed on the battery housing 301 and in front of the cabin 16 (see FIG. 1). In the present embodiment, the equipment case 52 is fixed to an upper surface 302 in a state where the equipment case 52 is disposed at the central portion in the vehicle-width direction on the front part of the upper surface 302 of the battery housing 301. The equipment case 52 has a rectangular parallelepiped shape that is long in the vehicle-width direction. The internal space of the equipment case 52 is in communication with the internal space of the battery housing 301.

The plurality of first external terminals 53 include two first connectors 531 and 532 through which electric power is input or output, a service plug 533, and a voltage detection unit 534. In the present embodiment, the plurality of first external terminals 53 include, as the two first connectors, the fuel-cell connector 531 and the inverter connector 532. The fuel-cell connector 531 and the inverter connector 532 are provided on the upper side of the equipment case 52. The service plug 533 and the voltage detection unit 534 are provided on the outside in the vehicle-width direction of the equipment case 52.

The fuel-cell connector 531 is a connector to which electric power generated by the fuel cell 24 is input. The fuel-cell connector 531 is fixed to an upper surface 52a of the equipment case 52. The fuel-cell connector 531 has a connection port (first connection port) 531a to which one end of a cable 85 is connected. The connection port 531a opens inward in the vehicle-width direction. The other end of the cable 85 is connected to the fuel cell 24.

The inverter connector 532 is a connector that outputs electric power to the inverter 81. The inverter connector 532 has approximately the same size as the fuel-cell connector 531. The inverter connector 532 is fixed to the upper surface 52a of the equipment case 52. The inverter connector 532 has a connection port (first connection port) 532a to which one end of a cable 86 is connected. The connection port 532a opens inward in the vehicle-width direction. The other end of the cable 86 is connected to the inverter 81.

The fuel-cell connector 531 is disposed at the rear of the upper surface 52a of the equipment case 52. The inverter connector 532 is disposed in front of the fuel-cell connector 531, on the upper surface 52a of the equipment case 52. That is, the fuel-cell connector 531 and the inverter connector 532 are disposed on the upper surface 52a of the equipment case 52 so as to be offset from each other in the vehicle front-rear direction. Since the fuel-cell connector 531 and the inverter connector 532, which are the first connectors, are disposed on the upper surface 52a of the equipment case 52, the fuel-cell connector 531 and the inverter connector 532 are disposed above a low-voltage connector 571 and a high-voltage connector 572, which are second connectors described below.

The first junction 51 further includes a support base 54 fixed to the upper surface 52a of the equipment case 52, and a pair of clips 55 provided on the support base 54. The support base 54 is disposed inward relative to the fuel-cell connector 531 and the inverter connector 532 in the vehicle-width direction. The support base 54 extends in the vehicle front-rear direction. The pair of clips 55 are fixed on the upper side of the support base 54 at intervals in the vehicle front-rear direction.

One clip 55 is configured to clamp the outer periphery of the cable 85 connected to the fuel-cell connector 531. The other clip 55 is configured to clamp the outer periphery of the cable 86 connected to the inverter connector 532. Accordingly, the cables 85 and 86 connected to the connectors 531 and 532 are fixed to the equipment case 52 via the pair of clips 55 and the support base 54.

The service plug 533 is provided on the side surface 52b of the equipment case 52 on the outside in the vehicle-width direction so that the service plug 533 is disposed near an openable/closable door 72 described below (see FIG. 11). The service plug 533 includes a base 533a and a plug 533b detachably attached to the base 533a. The base 533a is disposed in the equipment case 52 and fixed to the inner surface (a surface opposite to the side surface 52b) of the equipment case 52. The plug 533b, in a state of being attached to the base 533a, is exposed outward in the vehicle-width direction relative to the side surface 52b of the equipment case 52.

A portion of a power path (wiring) connected to the battery unit 30 is provided so as to pass through the inside of the base 533a of the service plug 533 and the inside of the plug 533b. When the plug 533b is removed from the base 533a, the power path is physically interrupted. Thus, a worker can safely perform maintenance work and the like by removing the plug 533b from the base 533a to interrupt the power path.

The voltage detection unit 534 is provided on the side surface 52b of the equipment case 52 so that the voltage detection unit 534 is disposed near an openable/closable door 72 described below (see FIG. 11). The voltage detection unit 534 is disposed on the side surface 52b of the equipment case 52 in front of the service plug 533. The voltage detection unit 534 confirms, for example, energization of the power path when the service plug 533 interrupts or energizes the power path. The voltage detection unit 534 of the present embodiment includes a pair of terminals 534a for measuring a voltage. Each terminal 534a is exposed outward relative to the side surface 52b of the equipment case 52 in the vehicle-width direction.

### [Second Junction]

The second junction 56 is disposed inward relative to the first junction 51 in the vehicle-width direction. The second junction 56 includes a plurality of second external terminals 57 disposed on the battery unit 30. The plurality of second external terminals 57 include the two second connectors 571 and 572 from which electric power is output, and an electrical-component connector 573. In the present embodiment, the plurality of second external terminals 57 include, as the two second connectors, the low-voltage connector 571 and the high-voltage connector 572.

The low-voltage connector 571 is a connector that outputs electric power to the first voltage converter 82. The low-voltage connector 571 is smaller than the fuel-cell connector 531 and the inverter connector 532. The low-voltage connector 571 is fixed to the upper surface 302 of the battery housing 301. The low-voltage connector 571 has a connection port (second connection port) 571a to which one end of a cable 87 is connected. The connection port 571a opens inward in the vehicle-width direction. The other end of the cable 87 is connected to the first voltage converter 82.

The high-voltage connector 572 is a connector that outputs electric power to the second voltage converter 83. The high-voltage connector 572 has the same size as the low-voltage connector 571. The high-voltage connector 572 is fixed to the upper surface 302 of the battery housing 301. The high-voltage connector 572 has a connection port (second connection port) 572a to which one end of the cable 88 is connected. The connection port 572a opens inward in the vehicle-width direction. The other end of the cable 88 is connected to the second voltage converter 83.

The low-voltage connector 571 is disposed at the rear of the high-voltage connector 572 on the upper surface 302 of the battery housing 301. That is, the low-voltage connector 571 and the high-voltage connector 572 are disposed on the upper surface 302 of the battery housing 301 so as to be offset from each other in the vertical direction.

The electrical-component connector 573 is a connector that outputs electric power to a low-voltage electrical component. The electrical-component connector 573 is fixed to the upper surface 302 of the battery housing 301. The electrical-component connector 573 is disposed in front of the high-voltage connector 572 on the upper surface 302 of the battery housing 301. The electrical-component connector 573 has a connection port 573a to which one end of a power line (not illustrated) is connected. The connection port 573a opens rearward. The other end of the power line is connected to a low-voltage electrical component.

The second junction 56 further includes a support base 58 fixed to the upper surface 302 of the battery housing 301, and a plurality of (here, three) clips 59 provided on the support base 58. The support base 58 is disposed inward in the vehicle-width direction relative to the low-voltage connector 571, the high-voltage connector 572, and the electrical-component connector 573. The support base 58 extends in the vehicle front-rear direction. The plurality of clips 59 are fixed on the upper side of the support base 58 at intervals in the vehicle front-rear direction.

One of the clips 59 is configured to clamp the outer periphery of the cable 87 connected to the low-voltage connector 571. Another one of the clips 59 is configured to clamp the outer periphery of the cable 88 connected to the high-voltage connector 572. The remaining one of the clips 59 is configured to clamp the outer periphery of the power line connected to the electrical-component connector 573. Accordingly, the cables 87 and 88 and the power line connected to the connectors 571, 572, and 573 are fixed to the battery housing 301 via the plurality of clips 59 and the support base 58.

### [Cover]

As illustrated in FIGs. 11 and 12, the cover 70 includes a cover body 71 and the openable/closable door 72 provided on the cover body 71. The cover body 71 is formed to cover the equipment case 52 of the first junction 51 and all the first external terminals 53, and to cover all the second external terminals 57 of the second junction 56. An opening 715 is formed inside the cover body 71 in the vehicle-width direction. The cables 85 to 88 and the power line respectively connected to the connection ports 531a, 532a, 571a, 572a, and 573a of the connectors 531, 532, 571, 572, and 573 are drawn out toward the vehicle body 11 side from the opening 715 of the cover body 71.

The cover body 71 is formed in a substantially trapezoidal shape in side view in the vehicle-width direction. The cover body 71 has a front wall 711, a rear wall 712, an upper wall 713, and a sidewall 714. The front wall 711 is disposed slightly in front of a front surface 303 of the battery housing 301 and extends in the vehicle-width direction. A lower portion 711a of the front wall 711 is disposed to face an upper portion of the front surface 303 of the battery housing 301. An upper portion 711b of the front wall 711 is inclined so that the upper part is gradually rearward.

The rear wall 712 is disposed at the rear of the equipment case 52 and extends in the vehicle-width direction. An upper portion 712b of the rear wall 712 is inclined so that the upper part is gradually frontward. The upper wall 713 is disposed above the fuel-cell connector 531 and the inverter connector 532 and extends in the vehicle-width direction. Both end edges of the upper wall 713 in the vehicle front-rear direction are connected to the upper end edge of the front wall 711 and the upper end edge of the rear wall 712.

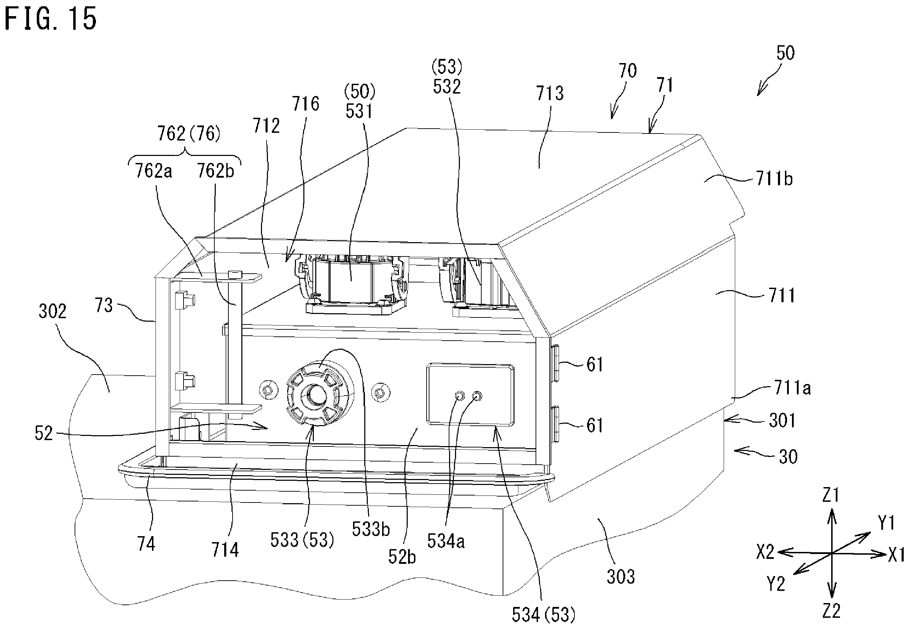

FIG. 15 is a perspective view of the relay junction 50 in a state in which the openable/closable door 72 of the cover 70 is opened, as viewed from the outer side in the vehicle-width direction and from the front. In FIG. 15, illustration of the openable/closable door 72 is omitted. As illustrated in FIG. 15, the sidewall 714 of the cover body 71 is disposed outward relative to the service plug 533 and the voltage detection unit 534 in the vehicle-width direction, and extends in the vehicle front-rear direction. The height size of the sidewall 714 is smaller than the height sizes of the front wall 711 and the rear wall 712.

In the present embodiment, the height size of the sidewall 714 is set to a size that allows access to the service plug 533 and the voltage detection unit 534 from the outer side of the sidewall 714 in the vehicle-width direction. Both end edges of the sidewall 714 in the vehicle front-rear direction are connected to the lower end edges outside the front wall 711 and the rear wall 712 in the vehicle-width direction. Accordingly, an opening 716 is also formed outside the cover body 71 in the vehicle-width direction. The opening 716 is covered by the openable/closable door 72.

As illustrated in FIGs. 11, 12, and 15, the cover 70 further includes a first sealing member 73 and a second sealing member 74. The first sealing member 73 is a resin or rubber member and is provided outside the cover body 71 in a vehicle-width direction. The first sealing member 73 is fixed along the outer end edge in the vehicle-width direction of each of the front wall 711, the rear wall 712, and the upper wall 713, and along the upper end edge of the sidewall 714. When the openable/closable door 72 is closed with respect to the cover body 71, the openable/closable door 72 comes into close contact with the first sealing member 73. Accordingly, the first sealing member 73 provides a seal between the cover body 71 and the openable/closable door 72.

The second sealing member 74 is a resin or rubber member and is provided on the lower side of the cover body 71. The second sealing member 74 is fixed along each lower end edge of the rear wall 712 and the sidewall 714. The lower end portion of the second sealing member 74 is in close contact with the upper surface 302 of the battery housing 301. Accordingly, the second sealing member 74 provides a seal between the cover body 71 and the battery housing 301.

### [Openable/Closable Door]

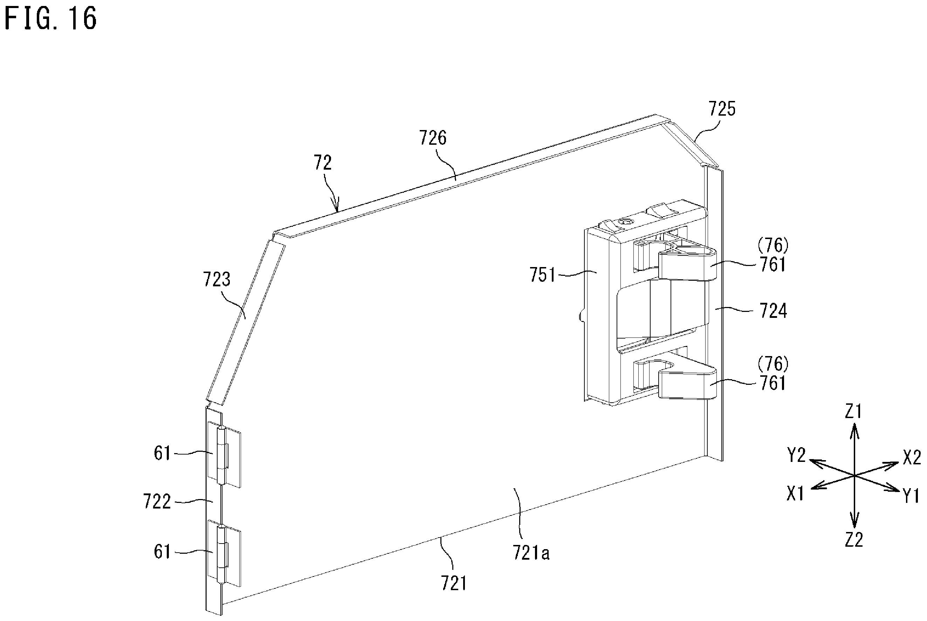

FIG. 16 is a perspective view of the openable/closable door 72 illustrated in FIG. 11 as viewed from the inner side in the vehicle-width direction. In FIGs. 11, 15, and 16, the openable/closable door 72 is provided outside the cover body 71 in the vehicle-width direction. The openable/closable door 72 includes a door body 721 and a plurality of flange plates 722, 723, 724, 725, and 726 provided on the door body 721. The door body 721 is a flat plate member formed in a substantially trapezoidal shape similarly to the shape of the cover body 71 in side view. The door body 721 is formed to have a size that covers the opening 716 of the cover body 71 from the outside in the vehicle-width direction. The first sealing member 73 is configured to be in close contact with an inner surface 721a inside the door body 721 in the vehicle-width direction.

The flange plates 722 and 723 protrude inward in the vehicle-width direction from the front end edge of the door body 721. The flange plates 724 and 725 protrude inward in the vehicle-width direction from the rear end edge of the door body 721. The flange plate 726 protrudes inward in the vehicle-width direction from the upper end edge of the door body 721. These flange plates 722 to 726, in the state illustrated in FIG. 11, overlap and cover the vehicle-width-direction outside of each outer surface of the front wall 711, the rear wall 712, and the upper wall 713 of the cover body 71.

The flange plate 722 is supported via a pair of hinges 61 so as to be rotatable about the vertical axis relative to the front wall 711 of the cover body 71. Accordingly, the openable/closable door 72 is supported so as to open and close the opening 716 relative to the cover body 71. When performing maintenance work or the like, a worker can access the service plug 533 and the voltage detection unit 534 from outside of the cover body 71 in the vehicle-width-direction by opening the openable/closable door 72.

The cover 70 further includes an operation mechanism 75 for a worker to open and close the openable/closable door 72. The operation mechanism 75 includes a frame body 751 provided on the rear side of the door body 721, and a handle 752 provided so as to be rotatable relative to the frame body 751. The frame body 751 is formed in a rectangular frame shape and is disposed penetrating the door body 721 in the vehicle-width direction. The handle 752 is formed in a rectangular plate shape. The handle 752 is disposed within the frame body 751 and is exposed outward in the vehicle-width direction. A worker can open and close the openable/closable door 72 with respect to the frame body 751 by hooking fingers on the handle 752.

The cover 70 further includes a lock mechanism 76 that locks the openable/closable door 72 in a state of being closed with respect to the cover body 71. The lock mechanism 76 includes a pair of hooks 761 provided on the operation mechanism 75, and an engagement portion 762 provided on the cover body 71. The pair of hooks 761 are integrally provided with the handle 752 on the back side (inside in the vehicle-width direction) of the handle 752, spaced apart from each other in the vertical direction. The pair of hooks 761 protrude inward from the inner surface 721a of the door body 721 in the vehicle-width direction. The pair of hooks 761 are rotatable with respect to the frame body 751 together with the handle 752.

The engagement portion 762 is disposed in the cover body 71. The engagement portion 762 includes brackets 762a fixed to the rear wall 712, and a shaft 762b fixed to the brackets 762a. The shaft 762b extends in the vertical direction at a position facing the pair of hooks 761, and both end portions of the shaft 762b in the vertical direction are fixed to the brackets 762a. Engagement of the pair of hooks 761 with the shaft 762b locks the openable/closable door 72 in a closed state. When a worker rotates the pair of hooks 761 together with the handle 752 from this state, engagement between the pair of hooks 761 and the shaft 762b is released. As a result, locking of the openable/closable door 72 by the operation mechanism 75 is released.

### [Operation and Effect of Embodiment]

According to the work vehicle 10 of the present embodiment, the first junction 51 (the equipment case 52 and the first external terminal 53) and the second junction 56 (the second external terminal 57) disposed on the battery unit 30 are covered by the cover 70, and therefore adhesion of mud or the like to the first junction 51 and the second junction 56 can be suppressed. As a result, a worker can efficiently perform work on the electrical system.

The cover 70 includes the openable/closable door 72 that enables access to the service plug 533 and the voltage detection unit 534 covered by the cover body 71. As a result, opening the openable/closable door 72 enables easy access to the service plug 533 and the voltage detection unit 534, and thus enables work on the electrical system to be performed more efficiently. Specifically, interruption of a power path by the service plug 533 can be easily performed. In addition, energization of the power path can be easily checked by the voltage detection unit 534.

The first connectors 531 and 532 of the first external terminal 53 and the second connectors 571 and 572 of the second external terminal 67 are arranged at different positions in the vertical direction. Such arrangement facilitates connection of the cables 85 to 88 to the first connectors 531 and 532 and the second connectors 571 and 572, respectively, and thus enables work on the electrical system to be performed more efficiently.

The first connection ports 531a and 532a of the first connectors 531 and 532 and the second connection ports 571a and 572a of the second connectors 571 and 572 each open inward in the vehicle-width direction. Thus, the cables 85 to 88 connected to the first connection ports 531a and 532a and the second connection ports 571a and 572a, respectively, can be drawn out inward in the vehicle-width direction. As a result, a wiring length of each cable 85 to 88 can be shortened as compared with a case where each cable 85 to 88 is drawn out outward in the vehicle-width direction.

Since the cover 70 has the opening 715 inside in the vehicle-width direction, the cables 85 to 88 respectively connected to the connectors 531, 532, 571, and 572 can be easily drawn out from the opening 715 of the cover 70. Thus, work on the electrical system can be performed more efficiently.

The second connectors 571 and 572 disposed at a lower position are disposed further inward in the vehicle-width direction and lower than the first connectors 531 and 532 disposed at a higher position. Such arrangement further facilitates connection of the cables 85 to 88 to the first connectors 531 and 532 and the second connectors 571 and 572, respectively, and thus enables work on the electrical system to be performed more efficiently.

The equipment case 52 is arranged in front of the cabin 16 on the battery unit 30. As a result, the equipment case 52 can be arranged on the battery unit 30 without interfering with the cabin 16.

The cover 70 is disposed at a position visible from the driver's seat 15 in the cabin 16 through the windshield 165 and through the side window 166. As a result, a worker seated in the driver's seat 15 can easily visually recognize, through the windshield 165 of the cabin 16, that the first junction 51 and the second junction 56 are covered by the cover 70.

### [Others]

The embodiment disclosed herein is illustrative in all respects and is not restrictive. The scope of the present invention is not limited to the above-described embodiment, and is indicated by the claims, and includes all modifications within the meaning and scope equivalent to configurations described in the claims.

For example, the relay junction 50 may be disposed at a position other than the position in the above-described embodiment, as long as the relay junction 50 is on the battery unit 30. The cover 70 of the relay junction 50 only needs to cover at least the equipment case 52. The voltage detection unit 534 of the first junction 51 may be, other than the above-described embodiment, a display panel or the like that displays a measured voltage value. The second connectors of the second junction 56 are not limited to the low-voltage connector 571 and the high-voltage connector 572, and may be, for example, connectors into which electric power is input. The respective positions of the first external terminal 53 of the first junction 51 and the second external terminal 57 of the second junction 56 may be the positions other than the positions in the above-described embodiment.

### REFERENCE SIGNS LIST

- 10: work vehicle
- 11: vehicle body
- 12: traveling device
- 13: tank
- 14: drive device
- 15: driver's seat
- 16: cabin
- 17: installation frame
- 21: tank unit
- 22: pipe
- 22f: front pipe
- 22r: rear pipe
- 24: fuel cell
- 24a: upper surface
- 25: filling unit
- 26: filling port
- 30: battery unit
- 31: motor
- 32: front frame
- 33: gear case
- 34: hood
- 34a: upper surface
- 35: discharge path
- 37: support frame
- 38: fixed frame portion
- 38a: mount surface
- 39: coupling frame portion
- 41: chassis
- 43: coupling device
- 45: first lateral frame
- 46: second lateral frame
- 47: fender
- 48: first radiator
- 48a: upper surface
- 49: second radiator
- 49a: upper surface
- 50: relay junction
- 51: first junction
- 52: equipment case
- 52a: upper surface
- 52b: side surface
- 53: first external terminal
- 54: support base
- 55: clip
- 56: second junction
- 57: second external terminal
- 58: support base
- 59: clip
- 61: hinge
- 70: cover
- 71: cover body
- 72: openable/closable door
- 73: first sealing member
- 74: second sealing member
- 75: operation mechanism
- 76: lock device
- 81: inverter
- 82: first voltage converter
- 83: second voltage converter
- 85: cable
- 86: cable
- 87: cable
- 88: cable
- 111: front cover
- 111a: upper surface
- 121: front wheel
- 122: rear wheel
- 151: steering wheel
- 162: front pillar
- 163: rear pillar
- 164: roof
- 165: windshield
- 166: side window
- 167: step
- 168: bottom
- 171: upper frame portion
- 172: front frame portion
- 173: rear frame portion
- 175: reinforcing frame portion
- 211: tank case
- 212: valve unit
- 213: openable/closable door
- 241: cell casing
- 242: fuel cell stack
- 300: battery
- 301: battery housing
- 302: upper surface
- 303: front surface
- 334: PTO shaft
- 481: first fan
- 491: second fan
- 531: fuel-cell connector (first connector)
- 531a: connection port (first connection port)
- 532: inverter connector (first connector)
- 532a: connection port (first connection port)
- 533: service plug
- 533a: base
- 533b: plug
- 534: voltage detection unit
- 534a: terminal
- 571: low-voltage connector (second connector)
- 571a: connection port (second connection port)
- 572: high-voltage connector (second connector)
- 572a: connection port (second connection port)
- 573: electrical-component connector
- 573a: connection port
- 711: front wall
- 711a: lower portion
- 711b: upper portion
- 712: rear wall
- 712b: upper portion
- 713: upper wall
- 714: sidewall
- 715: opening
- 716: opening
- 721: door body
- 721a: inner surface
- 722: flange plate
- 723: flange plate
- 724: flange plate
- 725: flange plate
- 726: flange plate
- 751: frame body
- 752: handle
- 761: hook
- 762: engagement portion
- 762a: bracket
- 762b: shaft

## Claims

1. A work vehicle comprising:
a vehicle body;
a fuel cell installed on the vehicle body;
a battery unit configured to store electric power generated by the fuel cell;
a motor installed on the vehicle body and driven by electric power stored in the battery unit;
an equipment case disposed on the battery unit; and
a cover that covers the equipment case.

2. The work vehicle according to claim 1, further comprising
a first external terminal provided outside the equipment case, wherein
the cover includes:
a cover body that covers the equipment case and the first external terminal; and
an openable/closable door provided on the cover body for access to the first external terminal.

3. The work vehicle according to claim 1 or 2, further comprising:
a first junction including the equipment case and a first external terminal provided outside the equipment case; and
a second junction including a second external terminal disposed on the battery unit, wherein
the cover covers the first junction and the second junction.

4. The work vehicle according to claim 3, wherein
the first external terminal includes a first connector to which electric power is input or output,
the second external terminal includes a second connector to which electric power is input or output, and
the first connector is disposed higher than the second connector.

5. The work vehicle according to claim 4, wherein
the battery unit is disposed outward relative to the vehicle body in the vehicle-width direction,
the first connector includes a first connection port to which a corresponding cable is connected,
the second connector includes a second connection port to which a corresponding cable is connected, and
each of the first connection port and the second connection port opens inward in the vehicle-width direction.

6. The work vehicle according to claim 5, wherein the cover includes, on an inside in the vehicle-width direction, an opening through which the cables connected to the first connection port and the second connection port are drawn out.

7. The work vehicle according to claim 5 or 6, wherein the second junction is disposed inward relative to the first junction in the vehicle-width direction on the battery unit.

8. The work vehicle according to claim 7, wherein
the cover includes:
a cover body that covers the first junction and the second junction; and
an openable/closable door provided outside the cover body in the vehicle-width direction.

9. The work vehicle according to claim 8, wherein
the first external terminal includes a service plug provided outside the equipment case in the vehicle-width direction and configured to interrupt a power path, and
the service plug is disposed near the openable/closable door.

10. The work vehicle according to claim 8 or 9, wherein
the first external terminal includes a voltage detection unit that is provided outside the equipment case in the vehicle-width direction and that checks energization of a power path, and
the voltage detection unit is disposed near the openable/closable door.

11. The work vehicle according to any one of claims 1 to 10, further comprising:
a driver's seat installed on the vehicle body;
a cabin having the driver's seat therein; and
a traveling device including a front wheel and a rear wheel, wherein
the battery unit is disposed between the front wheel and the rear wheel outward relative to the vehicle body in the vehicle-width direction, and
the equipment case is disposed in front of the cabin on the battery unit.

12. The work vehicle according to claim 11, wherein
the cabin includes a windshield, and
the cover is disposed at a position visually recognizable from the driver's seat through the windshield.

13. The work vehicle according to claim 11, wherein
the cabin includes a side window, and
the cover is disposed at a position visually recognizable from the driver's seat through the side window.
